# EUROPEAN PATENT SPECIFICATION

(11) **EP 2 703 963 B1**
(45) Date of publication and mention of the grant of the patent: **12.02.2020**
(21) Application number: 12777100.4
(22) Date of filing: 27.04.2012
(51) Int. Cl.: G06F 3/041, G06F 3/045

(54) **SPACER-LESS INPUT DEVICE**
ABSTANDSSTÜCKLOSE EINGANGSVORRICHTUNG
DISPOSITIF D'ENTRÉE SANS DISPOSITIF D'ESPACEMENT

(30) Priority: 29.04.2011 JP 2011102589
(43) Date of publication of application: 05.03.2014
(73) Proprietor: Nissha Printing Co., Ltd., Kyoto-shi, Kyoto 604-8551 (JP)
(72) Inventor: KAI, Yoshihiro, Kyoto-shi Kyoto 6048551 (JP); MORITA, Junpei, Kyoto-shi Kyoto 6048551 (JP); HASHIMOTO, Takao, Kyoto-shi Kyoto 6048551 (JP); SHIBATA, Junichi, Kyoto-shi Kyoto 6048551 (JP); TAKAI, Yuichiro, Kyoto-shi Kyoto 6048551 (JP); ENDO, Yuko, Kyoto-shi Kyoto 6048551 (JP)
(74) Representative: Hoffmann Eitle
(86) International application number: PCT/JP2012/061451
(87) International publication number: WO 2012/147948

(56) References cited:
- EP-A2- 0 189 590
- EP-A2- 2 278 443
- WO-A2-2009/108334
- JP-A- 1 014 630
- JP-A- 1 132 017
- JP-A- 6 342 332
- JP-A- 7 146 755
- JP-A- 2002 007 050
- JP-A- 2010 055 453
- JP-A- 2011 003 104
- JP-A- 2011 003 105
- US-A1- 2006 147 701

## Description

### TECHNICAL FIELD

The present invention relates to an input device that is applicable to any one of a slate PC, a mobile phone, a portable game machine, an electronic dictionary, a vehicle navigation system, a personal computer, a digital camera, a video camera, a portable MD (PMD), and other portable devices.

### BACKGROUND ART

There has been conventionally known a touch panel of a resistive film type as the input device mentioned above. Currently, an analog touch panel, which is a primary touch panel of the resistive film type, includes an upper electrode plate and a lower electrode plate. The upper electrode plate has an upper base member as a transparent flexible insulating base member, and an upper electrode formed entirely at the center on a lower surface of the upper base member. The lower electrode plate has a lower base member as a transparent insulating base member, and a lower electrode formed entirely at the center on an upper surface of the lower base member. One of the electrodes is made of a transparent conductive film provided with bus bars at both ends in an X axis direction, while the other one of the electrodes is made of a transparent conductive film provided with bus bars at both ends in a Y axis direction. The touch panel is configured by laminating the upper electrode plate and the lower electrode plate such that dot spacers are interposed between the conductive films.

However, the analog touch panel of the resistive film type detects a pressed down point from a voltage value at a conducted point by pressing down. In principle, when two or more points are simultaneously pressed down, in other words, when the so-called multiple touch is performed, it is impossible to identify the respective pressed down points.

In view of the above, the applicant of the present application has proposed a multi touch panel of a resistive film type, which is of the resistive film type but can simultaneously detect multiple points (see Patent Literature1). More specifically, the touch panel is configured by an upper electrode plate that includes an upper base member as a transparent flexible insulating base member and an upper electrode group formed on a lower surface of the upper base member, and a lower electrode plate that includes a lower base member as a transparent insulating base member and a lower electrode group formed on an upper surface of the lower base member. The upper electrode group includes p (p is a positive integer equal to or more than two) upper electrodes U1-Up each having a rectangular shape and a longitudinal direction parallel to an X axis. The upper electrodes are each made of a transparent conductive film provided with bus bars at both ends in the longitudinal direction thereof. The lower electrode group includes q (q is a positive integer equal to or more than two) lower electrodes L1-Lq each having a rectangular shape and a longitudinal direction parallel to a Y axis. The lower electrodes are each made of a transparent conductive film provided with bus bars at both ends in the longitudinal direction thereof. The upper electrode plate and the lower electrode plate are laminated such that dot spacers are interposed between the conductive films . In the touch panel technique, a bus bar is a pattern used for application of voltage and is provided at an end of an electrode so as to have a width substantially equal to the width of the electrode. A routing wire is extended from the bus bar to a frame portion of the touch panel.

In order to simultaneously detect multiple points with use of the multi touch panel of the resistive film type, there are prepared, in addition to the touch panel functioning as a sensor portion, matrix detection means, matrix storage means, and analog detection means, which function as a controller portion. The matrix detection means performs digital matrix detection to determine an intersecting matrix at a pressed down point. The matrix is stored by the matrix storage means. The analog detection means performs analog detection on the electrodes configuring the intersecting matrix stored by the matrix storage means, so as to calculate a position of the pressed down point.

There is another method, which is the so-called digital method, as a multi touch panel of the resistive film type. Such a multi touch panel is of the resistive film type, but is capable of simultaneously detecting multiple points (see Patent Literature 2). More specifically, the touch panel is configured by an upper electrode plate that includes an upper base member as a transparent flexible insulating base member and an upper electrode group formed on a lower surface of the upper base member, and a lower electrode plate that includes a lower base member as a transparent insulating base member and a lower electrode group formed on an upper surface of the lower base member. The upper electrode group includes p (p is a positive integer equal to or more than two) upper electrodes U1-Up each having a rectangular shape and a longitudinal direction parallel to an X axis. The upper electrodes are each made of a transparent conductive film provided with a bus bar at an end in the longitudinal direction thereof. The lower electrode group includes q (q is a positive integer equal to or more than two) lower electrodes L1-Lq each having a rectangular shape and a longitudinal direction parallel to a Y axis. The lower electrodes are each made of a transparent conductive film provided with a bus bar at an end in the longitudinal direction thereof. The upper electrode plate and the lower electrode plate are laminated such that dot spacers are interposed between the conductive films.

In order to simultaneously detect multiple points with use of the digital multi touch panel of the resistive film type, there is prepared, in addition to the touch panel functioning as a sensor portion, matrix detection means functioning as a controller portion. The matrix detection means performs digital matrix detection to determine an intersecting matrix at a pressed down point, so as to calculate a position of the pressed down point.

Also, document WO 2009/108334 A2 discloses an input device as defined in the preamble of claim 1.

### CITATION LIST

### PATENT LITERATURES

Patent Literature 1: JP 2010-55453 A
Patent Literature 2: JP 59-71216 A

### SUMMARY OF THE INVENTION

### TECHNICAL PROBLEM

However, in each of the multi touch panels of the resistive film type, external light is reflected at an interface between the surface provided with the upper electrode group of the upper electrode plate and a space, and at an interface between the space and the surface provided with the lower electrode group of the lower electrode plate. Furthermore, Newton's rings are likely to be generated depending on a gap size of the space between the upper electrode plate and the lower electrode plate, thereby resulting in problematic visuality.

Furthermore, the dot spacer is preferably removed in order to achieve a light impact load. However, in this case, there is a need to solve a problem that the upper transparent electrode base member is warped excessively to operate erroneously.

Moreover, the digital multi touch panel of the resistive film type has realized a spurious pressure sensitive function of detecting, responsive to input with use of a soft matter such as a finger, difference between the number of terminals of the upper and lower electrode groups made in contact with each other by input with large pressing force and the number of terminals of the upper and lower electrode groups made in contact with each other by input with small pressing force. However, there has been a problem that the pressure sensitive function is not effective upon input with a solid matter such as a stylus pen, which causes no increase or decrease of the number of input digits.

Therefore, it is an object of the present invention to solve the problems mentioned above and provide a spacerless input device that suppresses reflection at an interface, prevents generation of Newton's rings, improves visuality, does not operate erroneously even with no provision of dot spacers, and has a pressure sensitive function responsive even to input with a solid matter.

### SOLUTION TO PROBLEM

In order to achieve the object mentioned above, the present invention is as defined in the appended claims.

### EFFECTS OF THE INVENTION

According to the present invention, the pressure-sensitive conductive layer and the intermediate layer are filled in the gap between the surface provided with the upper transparent electrode group of the upper transparent electrode base member and the surface provided with the lower transparent electrode group of the lower transparent electrode base member. Thus, the present invention can suppress any reflection of light generated at two interfaces between the upper transparent electrode base member and the air layer as well as between the air layer and the lower transparent electrode base member. Therefore, it is possible to prevent generation of Newton's rings and improve visuality.

Furthermore, the pressure-sensitive conductive layer and the intermediate layer are filled in the gap between the surface provided with the upper transparent electrode group of the upper transparent electrode base member and the surface provided with the lower transparent electrode group of the lower transparent electrode base member. Moreover, the upper transparent electrode base member is rigid and thick, thereby avoiding excessive warp of the upper transparent electrode base member and erroneous operation.

The liquid repellent layer can prevent leak of the liquid configuring the intermediate layer to the portion to which the FPC is pressure-joined having less sticking strength as compared with the adhesive paste bonding the upper transparent electrode base member and the lower transparent electrode base member at the peripheral edges.

When the adhesive paste that bonds the upper transparent electrode base member and the lower transparent electrode base member at the peripheral edges is configured by the hardened layer made of hardening resin, it is possible to prevent leak of the liquid configuring the intermediate layer.

### BRIEF DESCRIPTION OF THE DRAWINGS

Fig. 1 is a sectional view of a spacerless input device according to an embodiment of the present invention.
Fig. 2 is an explanatory schematic view of a sensor portion of a spacerless input device according to an embodiment of the present invention.
Fig. 3 is an exploded perspective view of a slate PC of a touch window style, which includes the spacerless input device according to the embodiment.
Fig. 4 is a sectional view of the slate PC of the touch window style, which includes the spacerless input device according to the embodiment.
Fig. 5 is a sectional view of a slate PC having a bezel structure, which includes the spacerless input device according to the embodiment.
Fig. 6 is an explanatory sectional view of reflection at an interface in the spacerless input device according to the embodiment.
Fig. 7 is an explanatory sectional view of reflection at an interface in a conventional touch panel.
Fig. 8 is a sectional view of an example of a structure in which a pressure-sensitive sensor is provided to the conventional touch panel.
Fig. 9 is a sectional view showing the process of bonding an upper transparent electrode base member and a lower transparent electrode base member at peripheral edges thereof.
Fig. 10 is a sectional view of an example of provision of a liquid repellent layer in the spacerless input device according to the embodiment.
Fig. 11 is an explanatory schematic view of a sensor portion of a spacerless input device according to an embodiment of the present invention.
Fig. 12A is a graph indicating an FR curve according to an ideal example, and Fig. 12B is a graph indicating an FR curve according to an example of using narrow electrodes.
Fig. 13A is a view showing an example of detection with use of an upper electrode and a lower electrode, and Fig. 13B is a view showing an example of detection with use of a plurality of upper electrodes and a plurality of lower electrodes.
Fig. 14A is a view showing an example of warp with no hard coating layer, and Fig. 14B is a view showing an example of warp with a thick hard coating layer.
Fig. 15 is a graph indicating differences among FR curves of spacerless input devices that are modified in various manners.

### DESCRIPTION OF EMBODIMENTS

Embodiments of the present invention are described in detail below with reference to the drawings.

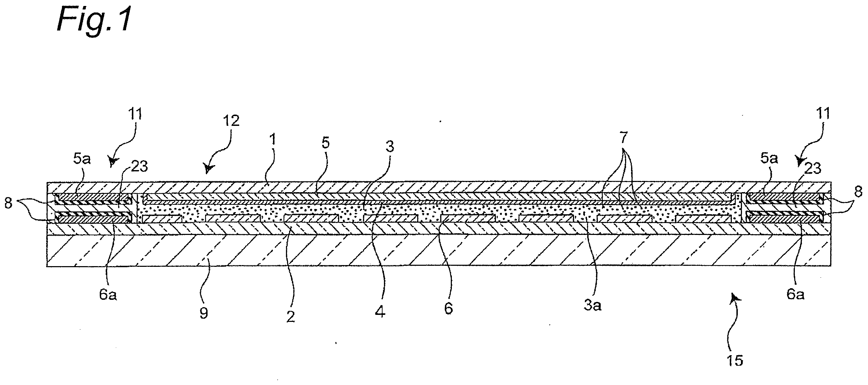

As shown in Fig. 1, a spacerless input device 15 according to a first embodiment of the present invention mainly includes an upper transparent electrode base member 1, a lower transparent electrode base member 2, adhesive paste 23, a pressure-sensitive conductive layer 3, an intermediate layer 4, and a transparent substrate 9. Described below is the spacerless input device 15 in a quadrilateral shape, for example.

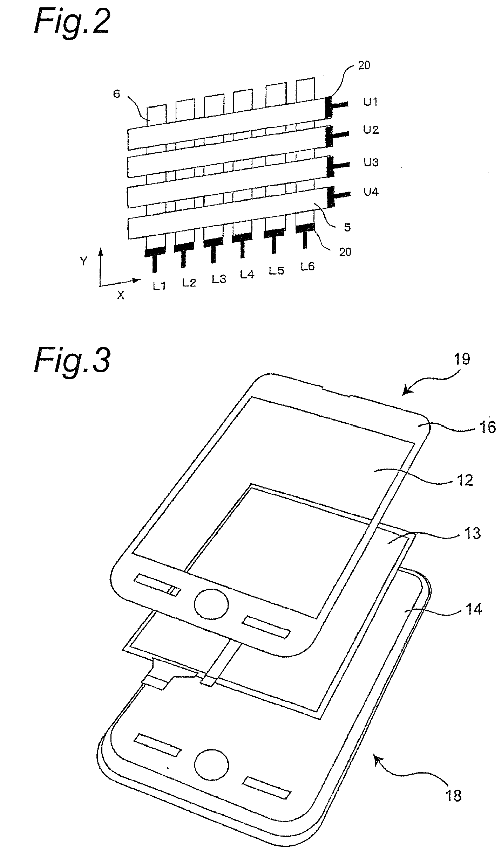

The upper transparent electrode base member 1 is configured by a quadrilateral film provided with an upper transparent electrode group 5 at a predetermined position in a transparent window 12 on a first surface (a lower surface of the upper transparent electrode base member 1 shown in Fig. 1, for example) . The upper transparent electrode group is formed by p (p is a positive integer equal to or more than two) upper transparent electrodes U1-Up each having a rectangular shape and a longitudinal direction parallel to an X axis as shown in Fig. 2, and bus bars each provided at an end in the longitudinal direction of the upper transparent electrodes. Preferably, the upper transparent electrode base member 1 is transparent, supports the upper transparent electrode group 5, and has electric properties (such as linearity) similar to those of a transparent electrode base member of an ordinary touch panel. The upper transparent electrode base member 1 has only to have a function of transmitting force applied to a second surface (an upper surface of the upper transparent electrode base member 1 shown in Fig. 1, for example) to the pressure-sensitive conductive layer 3 located below. Therefore, the upper transparent electrode base member 1 does not necessarily need to have flexibility. In a conventional touch panel, an electrode base member (film) needs to have strength of a certain degree so as not to be crushed by the air layer. However, in the present embodiment, the air layer is filled with the pressure-sensitive conductive layer 3 and the intermediate layer 4, so that it is possible to use a film thinner than a conventional base member.

The upper transparent electrode base member 1 can be configured by, for example, engineering plastic such as polycarbonate-based, polyamide-based, and polyether ketone-based engineering plastic, or a resin film 50 such as acrylic-based, polyethylene terephthalate-based, and polybutylene terephthalate-based resin film. Furthermore, an upper routing wire 5a is provided in a frame 11 in a quadrilateral frame shape surrounding the transparent window 12 at peripheral edges of the upper transparent electrode base member 1 on the first surface (the lower surface of the upper transparent electrode base member 1 shown in Fig. 1, for example) around the upper transparent electrode group 5. The upper routing wire 5a is made of silver or the like by printing, for example, and is connected to bus bars 20 of the upper transparent electrodes U1-Up. The transparent window 12 is located inside the frame 11 and functions as an input unit of the input device 15. The upper routing wire 5a is covered with an insulating resist layer 8 except at portions to which FPCs (Flexible Printed Circuits) 17 are pressure joined.

The lower transparent electrode base member 2 is configured by a quadrilateral film provided with a lower transparent electrode group 6 on a surface (an upper surface of the lower transparent electrode base member 2 shown in Fig. 1, for example) facing the surface provided with the upper transparent electrodes 5 at the predetermined position in the transparent window 12. The lower transparent electrode group 6 is formed by q (q is a positive integer equal to or more than two) lower transparent electrodes L1-Lq each having a rectangular shape and a longitudinal direction parallel to a Y axis as shown in Fig. 2, and bus bars 20 each provided at an end in the longitudinal direction of the lower transparent electrodes. Preferably, the lower transparent electrode base member 2 is transparent, supports the lower transparent electrode group 6, and has electric properties (such as linearity) similar to those of a transparent electrode base member of an ordinary touch panel. A lower routing wire 6a is provided in the frame 11 in the quadrilateral frame shape at peripheral edges of the lower transparent electrode base member 2 on a surface facing the surface provided with the upper transparent electrodes (an upper surface of the lower transparent electrode base member 2 shown in Fig. 1, for example) around the lower transparent electrode group 6. The lower routing wire 6a is made of silver or the like by printing, for example, and is connected to the bus bars 20 of the lower transparent electrodes L1-Lq. The lower routing wire 6a is covered with an insulating resist layer 8 except at portions to which the FPCs 17 are pressure-joined. The lower transparent electrode base member 2 can be configured by, for example, engineering plastic such as polycarbonate-based, polyamide-based, and polyether ketone-based engineering plastic, or a resin film such as acrylic-based, polyethylene terephthalate-based, and polybutylene terephthalate-based resin film.

The upper transparent electrodes and the lower transparent electrodes are configured as thin films that can be made of a metal oxide such as tin oxide, indium oxide, antimony oxide, zinc oxide, cadmium oxide, or ITO, a metal such as gold, silver, copper, tin, nickel, aluminum, or palladium, or a conductive polymer.

The lower transparent electrode base member 2 is provided on a lower surface thereof with the transparent substrate 9 that supports the upper transparent electrode base member 1, the lower transparent electrode base member 2, and the like. The transparent substrate 9 has functions (such as flexural rigidity and optical properties) similar to those of a transparent substrate of an ordinary touch panel. The transparent substrate can be made of glass, polycarbonate, acryl, or the like, and may be 0.55 to 1.1 mm thick, for example. In a case where the transparent electrode base members and the like can be supported by a different member, the transparent substrate may not be provided.

In order to bond the upper transparent electrode base member 1 and the lower transparent electrode base member 2, the frame 11 surrounding the transparent window 12 needs to be provided with the adhesive paste 23 in a frame shape where the intermediate layer 4 is not provided. The adhesive paste 23 in the frame shape is provided except at portions to which the FPCs 17 are pressure-joined.

The pressure-sensitive conductive layer 3 is provided at least in the transparent window 12 functioning as the input unit of the input device 15 so as to be uniform in thickness. In an example, as shown in Fig. 1, the pressure-sensitive conductive layer 3 is formed on a region containing the lower transparent electrode group 6 on the surface provided with the lower transparent electrode group 6 of the lower transparent electrode base member 2. In other examples, the pressure-sensitive conductive layer 3 may be formed on a region containing the upper transparent electrode group 5 on the surface provided with the upper transparent electrode group 5 of the upper transparent electrode base member 1 (modification example 1 in accordance with the present invention), or may be formed on the region containing the transparent electrode group on each of the surface provided with the upper transparent electrode group 5 of the upper transparent electrode base member 1 and the surface provided with the lower transparent electrode group 6 of the lower transparent electrode base member 2 (modification example 2 not covered by the claims).

The pressure-sensitive conductive layer 3 contains, in an insulating base member portion 3a, a large number of pressure-sensitive particles 7 having electrical conductivity and being scattered. The base member portion 3a of the pressure-sensitive conductive layer 3 is preferably made of a material that is colorless and transparent, is insulating, is well adhesive to a surface to be provided, and erodes none of the upper transparent electrode group 5 and the lower transparent electrode group 6.

The base member portion 3a of the pressure-sensitive conductive layer 3 is several tens of µm (such as 5 µm to 80 µm) thick so as to allow tunneling current to flow between the pressure-sensitive particles 7. The base member portion is preferably formed by screen printing, for example. The thickness of the pressure-sensitive conductive layer 3 is preferably 5 µm or more in terms of manufacturability, and 80 µm or less in terms of an effective and reliable flow of the tunneling current. Herein, the tunneling current means a phenomenon that, in a case where conductive particles are not in direct contact with each other but are quite close to each other in nanometer order, probable existence density of electrons is not equal to zero between the conductive particles and therefore the electrons leak to cause current to flow. This phenomenon is described as the tunnel effect in the quantum mechanics. In a case where the pressure-sensitive particles 7 are transparent, the pressure-sensitive particles do not affect visuality. However, if the pressure-sensitive particles 7 are opaque, the particles need to be formed into smaller sizes and scattered in the base member portion 3a so as not to affect visuality. Preferred specific examples of the material for the base member portion 3a of the pressure-sensitive conductive layer 3 include colorless and transparent ink that does not repel the material for the pressure-sensitive conductive layer 3 from the surface provided with the transparent electrode group (when the material for the pressure-sensitive conductive layer 3 is applied to the surface provided with the transparent electrode group in order to form the pressure-sensitive conductive layer 3 on the surface provided with the transparent electrode group, the material is not poor in wettability and the applied surface is not brought into a state of not getting wet well), and erodes none of the transparent electrode groups 5 and 6.

The pressure-sensitive particles 7 need only to be undeformable for themselves, conductive so as to allow current to flow therethrough, and likely achieve the quantum tunnel effect to be described later. The pressure-sensitive particles 7 further need only to have particle diameters appropriate for printing. For example, in a case of being formed by screen printing, the particle diameters need only to be sized such that the particles can easily pass through a meshed member. Specific examples of the material for pressure-sensitive particles 7 include a QTC to be described later. The pressure-sensitive particles 7 are scattered in the base member portion 3a so as not to affect visuality and so as to allow current to flow therethrough.

For example, the pressure-sensitive conductive layer 3 is brought from an insulating state into a conductive state because tunneling current flows between adjacent ones of the large number of pressure-sensitive particles 7 that are conductive and included in the pressure-sensitive conductive layer 3, due to application of pressure, regardless of direct contact therebetween. An example of a composition of the pressure-sensitive conductive layer 3 is a Quantum Tunneling Composite available as a trade name "QTC Clear" from PERATECH LTD in Darlington, Great Britain.

The intermediate layer 4 is provided at least in the transparent window 12 functioning as the input unit of the input device 15 so as to be thoroughly uniform in thickness. In an example, as shown in Fig. 1, the transparent liquid-form intermediate layer 4 is interposed between the pressure-sensitive conductive layer 3 provided on the lower transparent electrode base member 2 and the region containing the upper transparent electrode group 5 of the upper transparent electrode base member 1 so as to completely fill a gap therebetween. In the case of the modification example 1 described above, the transparent liquid-form intermediate layer 4 is interposed between the pressure-sensitive conductive layer 3 provided on the upper transparent electrode base member 1 and the region containing the lower transparent electrode group 6 of the lower transparent electrode base member 1 so as to completely fill a gap therebetween. In the case of the modification example 2 described above, the transparent liquid-form intermediate layer 4 is interposed between the respective pressure-sensitive conductive layers 3, 3.

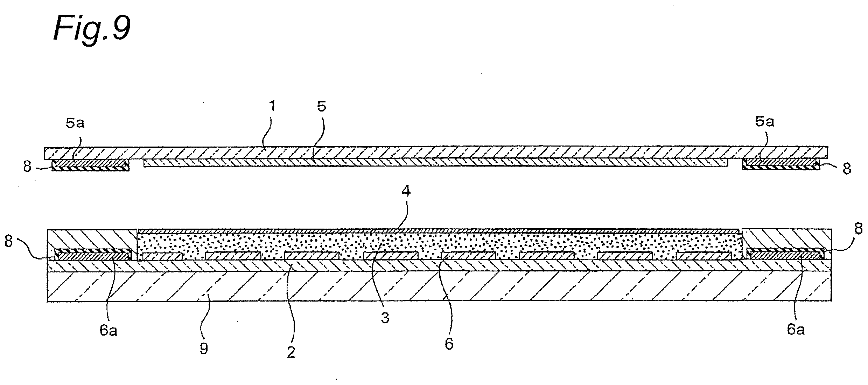

The intermediate layer 4 needs to be non-conductive and liquid. The liquid-form intermediate layer has high flexibility in shape, and therefore easily fills the gap when the upper transparent electrode base member 1 is laminated (see Fig. 9) . In the present description, a liquid-form is inclusive of a gel state.

The liquid-form intermediate layer 4 is movable even by small pressing force. Therefore, when force is applied with a finger, a pen, or the like from the second surface of the upper transparent electrode base member 1 (the upper surface of the upper transparent electrode base member 1 shown in Fig. 1, for example), the applied force can be transmitted to the pressure-sensitive conductive layer 3 at a substantially same level. More specifically, when pressing force is applied with a finger, a pen, or the like to the second surface of the upper transparent electrode base member 1 (the upper surface of the upper transparent electrode base member 1 shown in Fig. 1, for example), the applied force passes through the upper transparent electrode base member 1 in the thickness direction and is transmitted to the pressure-sensitive conductive layer 3. Then, the tunnel effect is exerted between the plurality of pressure-sensitive particles 7 in the pressure-sensitive conductive layer 3 and then, tunneling current flows between the plurality of pressure-sensitive particles 7, so that the upper transparent electrode and the lower transparent electrode right below a pressed point are conducted with each other. Variation in pressing force applied in the thickness direction (Z direction) of the input device 15 can be detected by an XY direction coordinate detecting unit (not shown) as variation in resistance value (by being converted into variation in voltage). Therefore, it is possible to detect position coordinates (XY coordinates) where the force is applied on the upper surface of the upper transparent electrode base member 1. As mentioned above, the intermediate layer 4 is movable even by small pressing force. The intermediate layer 4 is eliminated or made thin enough to allow current to flow right below the pressed point. Therefore, it is possible to detect variation in resistance value even if the intermediate layer 4 is non-conductive.

The intermediate layer 4 is preferably 1 µm to 1000 µm thick, and may be formed on the pressure-sensitive conductive layer 3 by coating, ink-jet printing, with use of a dispenser, or the like (see Fig. 9). The thickness of the intermediate layer 4 is preferably 1 µm or more in terms of manufacturability, and 1000 µm or less in terms of movability of the intermediate layer 4 by slight force and transmission of the applied force to the pressure-sensitive conductive layer 3 at a substantially same level.

Examples of the intermediate layer 4 include acrylic-based, silicone-based, fluorine-based, or alcohol-based inert liquid. Examples of commercially available materials include fluorine inert liquid (trade names "Fluorinert" and "Novec") manufactured by 3M, and silicon oil (trade names "KF" and "HIVAC") and alcoholic polyethylene glycol manufactured by Shin-Etsu Chemical Co., Ltd.

When force is applied to the upper surface of the upper transparent electrode base member 1, the applied force passes through the intermediate layer 4 and thus, current is cased to flow between the pressure-sensitive particles 7 in the pressure-sensitive conductive layer 3. Accordingly, the upper transparent electrode 5 and the lower transparent electrode 6 are conducted with each other. Therefore, the XY direction coordinate detecting unit can detect position coordinates (XY direction coordinates) where the force is applied, along the upper surface of the upper transparent electrode base member 1. More specifically, the XY direction coordinate detecting unit is connected to both of the upper transparent electrode group 5 and the lower transparent electrode group 6. In a state where voltage is applied from a power source to each terminal of the upper transparent electrode group 5, the XY direction coordinate detecting unit detects variation in voltage at each of the terminals of the upper transparent electrode group 5 and each of the terminals of the lower transparent electrode group 6, so as to detect position coordinates in the XY direction from the positions of the terminals where voltage is varied.

In this case, the position coordinates in the XY direction are detected in the state where the voltage is applied to the upper transparent electrode group 5. However, the present invention is not limited to this case. Alternatively, the position coordinates in the XY direction may be detected in a state where the voltage is applied to the lower transparent electrode group 6.

Meanwhile, a position in a Z direction is detected by a Z directional position detecting unit (not shown) . More specifically, the pressing force passes through the intermediate layer 4 and is applied to the pressure-sensitive conductive layer 3 interposed between the upper and lower electrodes, and current flows between the pressure-sensitive particles 7 in the pressure-sensitive conductive layer 3. Accordingly, at the terminals where XY input coordinates are detected in the previous process, variation in resistance value is generated between the terminal where input to the upper transparent electrode group 5 is detected and the terminal where input to the lower transparent electrode group 6 is detected right below the pressed point. Therefore, the Z directional position detecting unit can detect variation in force size.

The present embodiment shows the detection system in which the bus bars 20 are each formed at only one of the ends of the transparent electrodes in the upper transparent electrode group 5 and the lower transparent electrode group 6. However, the present invention is not limited to this case.

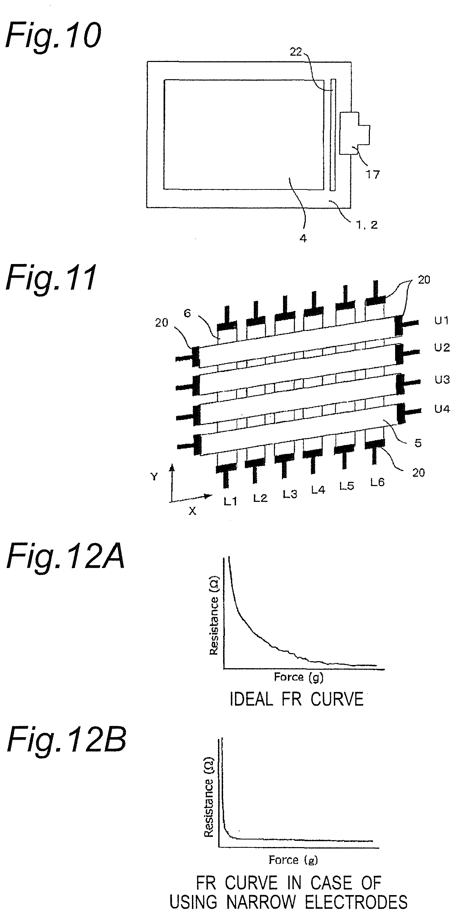

For example, as shown in Fig. 1 similarly to the first embodiment, a spacerless input device 15 according to a second embodiment of the present invention mainly includes an upper transparent electrode base member 1, a lower transparent electrode base member 2, adhesive paste 23, a pressure-sensitive conductive layer 3, an intermediate layer 4, and a transparent substrate 9. The upper transparent electrode base member 1 is configured by a quadrilateral film provided with an upper transparent electrode group 5 at a predetermined position in a transparent window 12 on a first surface thereof (a lower surface of the upper transparent electrode base member 1 shown in Fig. 1, for example). The upper transparent electrode group 5 includes p (p is a positive integer equal to or more than two) upper transparent electrodes U1-Up each having a rectangular shape and a longitudinal direction parallel to an X axis as shown in Fig. 11, and bus bars 20 provided at both ends in the longitudinal direction of the respective upper transparent electrodes.

Furthermore, in the spacerless input device 15 according to the second embodiment, the lower transparent electrode base member 2 is configured by a quadrilateral film provided with a lower transparent electrode group 6 on a surface (an upper surface of the lower transparent electrode base member 2 shown in Fig. 1, for example) facing the surface provided with the upper transparent electrodes 5 at the predetermined position in the transparent window 12. The lower transparent electrode group 6 includes q (q is a positive integer equal to or more than two) lower transparent electrodes L1-Lq each having a rectangular shape and a longitudinal direction parallel to a Y axis, and bus bars 20 provided at both ends in the longitudinal direction of the respective lower transparent electrodes (see Fig. 11).

Remaining portions according to the second embodiment are configured similarly to corresponding portions in the spacerless input device according to the first embodiment of the present invention.

Alternatively, the surface provided with the upper transparent electrode group 5 of the upper transparent electrode base member 1 may have regions to which FPCs 17 are pressure joined, and a liquid repellent layer 22 may be provided between the pressure-joined regions and a region containing the upper transparent electrode group 5. The liquid repellent layer 22 thus provided can prevent leak of liquid in the intermediate layer 4 (see Fig. 10).

Examples of the material for the liquid repellent layer 2 include a silicone-based or fluorine-based water repellent agent, which is to be applied. The liquid repellent layer 22 may be applied by screen printing, ink jet printing, with use of a dispenser, or the like.

The adhesive paste 23, which bonds the upper transparent electrode base member 1 and the lower transparent electrode base member 2 at peripheral edges thereof, may be provided as a hardened layer made of hardening resin. The hardened layer made of hardening resin, which is provided as the adhesive paste 23 bonding the peripheral edges, can prevent leak of the liquid in the intermediate layer 4. Examples of such hardening resin include UV curable resin and thermosetting resin.

Described next are slate PCs 18, 18A each serving as one example of a portable device in which the spacerless input device 15 is incorporated.

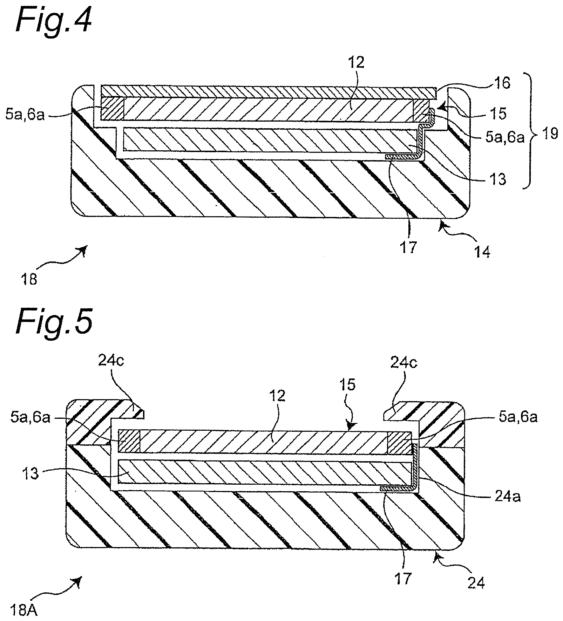

Figs. 3 and 4 each show a touch window 19 that is provided with printed decoration (a decorative layer 16) on a surface layer of the spacerless input device 15. The spacerless input device 15 is fitted in a first concavity 14a in a casing 14 such that an outer surface around the first concavity 14a in the casing 14 is flush with an outer surface of the spacerless input device 15. A liquid crystal or organic EL display 13 is fixed in a second concavity 14b formed in a bottom surface of the first concavity 14a. Indication on the display 13 is visible through the transparent window 12 of the spacerless input device 15. Reference sign 17 denotes an FPC connected to the routing wires 5a and 6a.

In such a configuration, in the touch window 19 provided with the printed decoration (the decorative layer 16), the circuitry is hidden by the decorative layer 16. Accordingly, the circuitry can be mounted on the surface. Therefore, it is possible to realize a thin and stylish design with no difference in height between the spacerless input device 15 and the casing 14. The touch panel is released from a bezel structure, thereby enabling reduction in thickness, which has not been realized in an ordinary touch panel.

In a different structure shown in Fig. 5, the circuitry such as the routing wires 5a and 6a is covered with a bezel 24c of the casing 4 such that the circuitry is not visible . The casing 24 is provided therein with a large concavity 24a in which the liquid crystal or organic EL display 13 and the spacerless input device 15 are fitted. The circuitry such as the routing wires 5a and 6a of the spacerless input device 15 is covered with the bezel 24c of the casing 4.

The embodiment described above can exert the following effects.

The pressure-sensitive conductive layer 3 and the intermediate layer 4 are filled in the gap between the surface provided with the upper transparent electrode group 5 of the upper transparent electrode base member 1 and the surface provided with the lower transparent electrode group 6 of the lower transparent electrode base member 2, thereby forming no air layer. Thus, suppressed is reflection of light generated at interfaces (more specifically, two interfaces between the upper transparent electrode base member 1 and the air layer as well as between the air layer and the lower transparent electrode base member 2). Therefore, it is possible to prevent generation of Newton's rings and improve visuality.

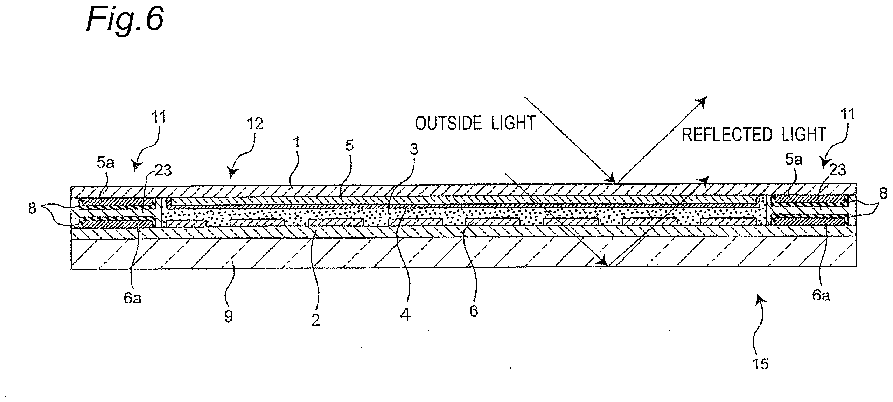

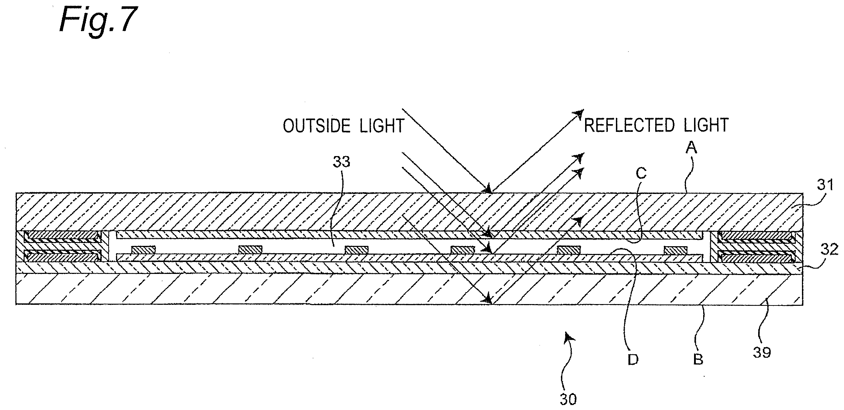

More specifically, as shown in Fig. 6, in general, light is remarkably reflected at an interface with air. However, there are only two layers, namely, an interface A between the upper surface of the upper transparent electrode base member 1 and the air layer outside the spacerless input device 15, and an interface B between the substrate 9 and the air layer outside the spacerless input device 15. Meanwhile, there are decreased two layers, namely, an interface C between the lower surface of the upper transparent electrode base member 1 and the air layer in the gap, and an interface D between the upper surface of the lower transparent electrode base member 2 and the air layer in the gap. Therefore, reflectance is reduced by about 15 to 20%, for example. To the contrary, as shown in Fig. 7, in a conventional touch panel 30, reflection was generated at four layers, namely, an interface A between an upper surface of an upper transparent electrode base member 31 and the air layer outside the touch panel 30, an interface C between a lower surface of the upper transparent electrode base member 31 and the air layer in a gap 33, an interface D between an upper surface of a lower transparent electrode base member 32 and the air layer in the gap 33, and an interface B between a substrate 39 and the air layer outside the touch panel 30. Furthermore, in a case where the gap for the air layer between upper transparent electrodes and lower transparent electrodes is significantly reduced in size, Newton's rings are generated inevitably. These facts have been deteriorated visuality.

Furthermore, the pressure-sensitive conductive layer 3 is laminated on at least one of the upper transparent electrode base member 1 and the lower transparent electrode base member 2. Moreover, the intermediate layer 4 is filled between the upper transparent electrode group 5 and the lower transparent electrode group 6 with the pressure-sensitive conductive layer 3 being interposed therebetween. Therefore, even in a case where the spacerless input device 15 is used in conditions of high humidity and high temperature, defects such as bedewing and misting do not occur between the upper transparent electrode base member 1 and the lower transparent electrode base member 2, because there is provided no air layer.

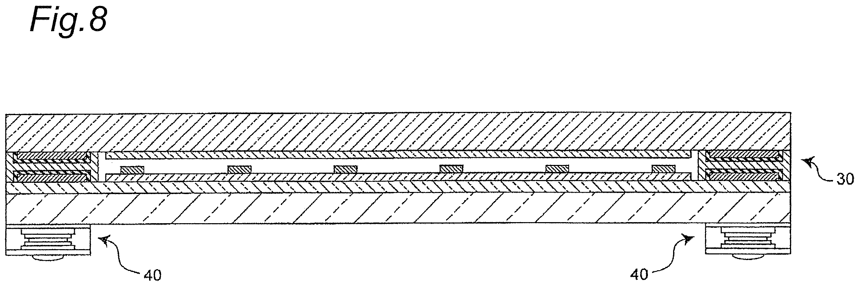

Moreover, there is no need to additionally provide any pressure-sensitive sensor outside the spacerless input device 15, such as therebelow, for detection of applied force. Therefore, the spacerless input device 15 can be reduced in thickness and size. To the contrary, in a case of considering conventional provision of a pressure-sensitive sensor on an inner surface of a touch panel, as shown in Fig. 8, a pressure-sensitive sensor 40 is laminated and bonded on the inner surface of the touch panel 30. Accordingly, the thickness of the pressure-sensitive sensor 40 is added to the thickness of the touch panel 30, which inevitably leads to increase in entire thickness of the touch panel. To the contrary, as the sensor in the embodiment, the pressure-sensitive sensor can be provided inside the structure of the touch panel itself, and the number of components is decreased, which enables reduction in cost. In addition, it is possible to provide the spacerless input device in the configuration apparently similar to that of an ordinary touch panel, wherein the spacerless input device can have the functions of detecting XY coordinates as well as sensing pressure, is quite compact in size, and has high performance.

Furthermore, the pressure-sensitive conductive layer 3 and the intermediate layer 4 are interposed between the upper transparent electrode base member 1 and the lower transparent electrode base member 2. Accordingly, there is no need to provide a conventional spacer. Therefore, it is unnecessary to perform the process of forming a spacer, which leads to reduction in cost.

The present invention is not limited to the embodiments having been described, but can be embodied in accordance with other various aspects. For example, the pressure-sensitive conductive layer 3 is not limited to a single layer. Alternatively, it is possible to configure the pressure-sensitive conductive layer with a plurality of layers.

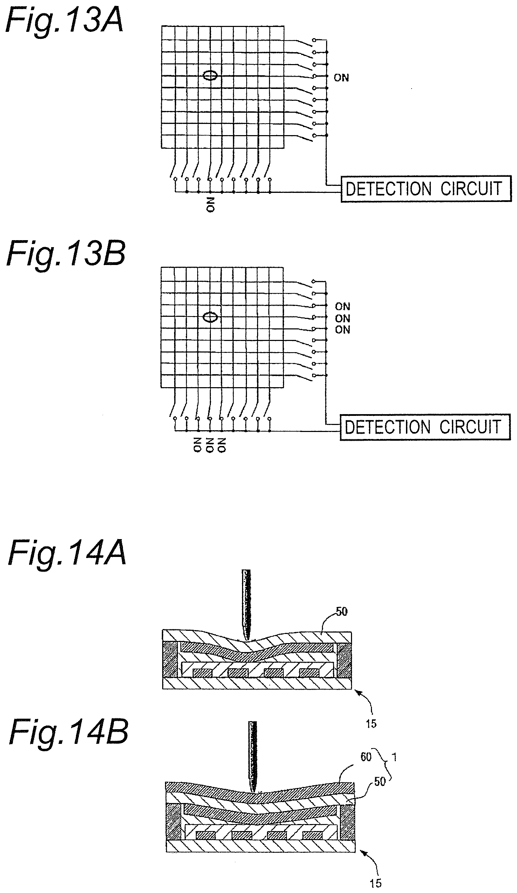

The upper transparent electrode base member 1 may include the resin film 50 and a thick hard coating layer 60 provided on a front surface of the resin film 50. The thick hard coating layer 60 thus provided allows easy control to increase the thickness of the entire upper transparent electrode base member 1. Fig. 14A is a view showing an example of warp with no hard coating layer, and Fig. 14B is a view showing an example of warp with the thick hard coating layer 60, on the front surface of the same resin film 50. In Fig. 14A, the warp is extremely localized, so that the area where the upper and lower electrodes are conducted with each other becomes small. On the other hand, in Fig. 14B, the warp is expanded to the periphery, so that the area where the upper and lower electrodes are conducted with each other becomes large.

If the upper and lower electrodes narrowed in width are used in order to accurately detect XY coordinates, the area is small at an intersection between the upper and lower electrodes. Accordingly, adequate pressure sensitive properties fail to be exhibited, as shown in Fig. 12B. Fig. 12A is a graph indicating an FR curve showing the relationship between Force (weighting) and Resistance (resistance value) according to an ideal example, and Fig. 12B is a graph indicating an FR curve showing the relationship between Force (weighting) and Resistance (resistance value) according to an example of using such narrow electrodes. Therefore, the thick hard coating layer 60 thus provided allows easy control to increase the thickness of the entire upper transparent electrode base member 1, and improves sensitivity of the pressure sensitive function.

A different measure can be considered against inadequate exhibition of the pressure sensitive function due to the narrowed upper and lower electrodes. For example, instead of detecting variation at an intersection by driving each one of the upper and lower electrodes (see Fig. 13A), plural upper electrodes and plural lower electrodes to be used for detection of pressure may be driven collectively to detect variation at the intersection (see Fig. 13B) . In this manner, an input load is reduced, the area of the electrodes to be used for detection of pressure is enlarged, and sensitivity is improved in the pressure sensitive function.

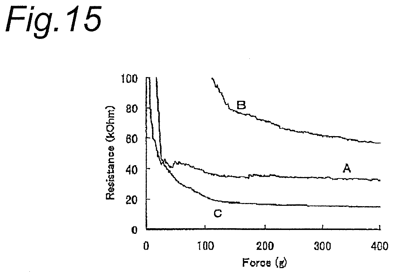

Fig. 15 is a graph indicating differences among FR curves of the spacerless input devices that are modified by provision of the thick hard coating layer 60 and by driving collectively the plural upper electrodes and the plural lower electrodes, as described earlier.
A: no hard coating layer being provided, and one upper electrode and one lower electrode being driven
B: a hard coating layer being provided, and one upper electrode and one lower electrode being driven
C: a hard coating layer being provided, and a plurality of upper electrodes and a plurality of lower electrodes being driven

As indicated in the graph, a curve B has a moderate line as compared with a curve A, whereas with a heavy input load. On the other hand, a curve C has a moderate line as compared with the curve A, as well as with a light input load.

By properly combining arbitrary embodiments of the aforementioned various embodiments, the effects owned by each of them can be made effectual.

### INDUSTRIAL APPLICABILITY

The spacerless input device according to the present invention can detect multiple input, and can detect XY plane coordinates as well as a Z coordinate due to pressing. The pressure-sensitive conductive layer and the intermediate layer are filled in the gap between the upper transparent electrode base member and the lower transparent electrode base member to eliminate the air layer. Thus, it is possible to prevent reflection at an interface and generation of Newton's rings, to thereby improve visuality. The spacerless input device is useful in a slate PC, a mobile phone, a portable game machine, an electronic dictionary, a vehicle navigation system, a personal computer, a digital camera, a video camera, a portable MD (PMD), or the like.

### REFERENCE SIGNS LIST

1 Upper transparent electrode base member
2 Lower transparent electrode base member
3 Pressure-sensitive conductive layer
3a Base member portion of pressure-sensitive conductive layer
4 Intermediate layer
5 Upper transparent electrode group
5a Upper routing wire
6 Lower transparent electrode group
6a Lower routing wire
7 Pressure-sensitive particle
8 Resist layer
9 Substrate
11 Frame
12 Transparent window
14 Casing
14a First concavity
14b Second concavity
15 Spacerless input device
16 Decorative layer
17 FPC
18, 18A Slate PC
19 Touch window
20 Bus bar
22 Liquid repellent layer
23 Adhesive paste
50 Resin film
60 Hard coating layer
U1-Up Upper transparent electrode
L1-Lq Lower transparent electrode

## Claims

1. An input device (15) comprising:
a thick upper transparent electrode base member (1) provided on a first surface with an upper transparent electrode group (5) that includes a plurality of upper transparent electrodes (U1-U4) each having a rectangular shape and a longitudinal direction parallel to an X axis, and bus bars (20) provided at, at least, one of the ends in the longitudinal direction of the upper transparent electrodes; and
a lower transparent electrode base member (2) provided on a first surface with a lower transparent electrode group (6) that includes a plurality of lower transparent electrodes (L1-L6) each having a rectangular shape and a longitudinal direction parallel to a Y axis, and bus bars (20) provided at, at least, one of the ends in the longitudinal direction of the lower transparent electrodes, the surface provided with the lower transparent electrode group (6) of the lower transparent electrode base member (2) and the surface provided with the upper transparent electrode group (5) of the upper transparent electrode base member (1) facing each other and being bonded together at peripheral edges;
the input device (15) further comprises a transparent pressure-sensitive conductive layer (3) formed on a region containing the transparent electrode group on one of the surface provided with the upper transparent electrode group (5) of the upper transparent electrode base member (1) and the surface provided with the lower transparent electrode group (6) of the lower transparent electrode base member (2);
**characterized in that** the input device (15) is not provided with dot spacers, instead a transparent liquid-form intermediate layer (4) is further interposed between the pressure-sensitive conductive layer (3) formed on the one of the transparent electrode base members and the region containing the transparent electrode group of the remaining one of the transparent electrode base members, wherein the transparent liquid-form intermediate layer (4) is configured by acrylic-based, silicone-based, fluorine-based, or alcohol-based inert liquid;
and **in that** the transparent liquid-form intermediate layer (4) is movable and the transparent pressure-sensitive conductive layer (3) configured such that, when pressing force is applied to a second surface of the upper transparent electrode base member (1) opposite to the first surface of the upper transparent electrode base member (1), the applied force causes quantum tunneling current to flow between pressure-sensitive particles (7) scattered in the pressure-sensitive conductive layer (3), thereby making the upper transparent electrode and the lower transparent electrode right below a pressed point to be conducted with each other, and the input device (15) detecting position coordinating where the force is applied along the second surface of the upper transparent electrode base member (1).

2. The input device (15) according to claim 1, wherein the bus bars (20) are provided at both ends in the longitudinal direction of the upper transparent electrodes and both ends in longitudinal direction of the lower transparent electrodes.

3. The input device (15) according to claim 1, wherein the bus bars (20) are provided at only one of the ends in the longitudinal direction of the upper transparent electrodes and only one of the ends in longitudinal direction of the lower transparent electrodes.

4. The input device (15) according to any one of claims 1 to 3, further comprising a Z direction detector that detects variation in magnitude of the force, when the pressing force is applied to the second surface of the upper transparent electrode base member (1), the applied force causing current to flow between the pressure-sensitive particles in the pressure-sensitive conductive layer (3), and variation in resistance value occurring between the upper transparent electrode and the lower transparent electrode right below the pressed point.

5. The input device (15) according to any one of claims 1 to 4, wherein the surface provided with the transparent electrode group of the transparent electrode base member has a region to which a Flexible Printed Circuit is pressure-joined, and a liquid repellent layer (22) is provided between the pressure-joined region and the region containing the transparent electrode group.

6. The input device (15) according to any one of claims 1 to 5, wherein adhesive paste (23) bonding the upper transparent electrode base member (1) and the lower transparent electrode base member (2) at the peripheral edges is configured by a hardened layer made of hardening resin.

7. The input device (15) according to any one of claims 1 to 6, wherein the upper transparent electrode base member (1) has a resin film (50) and a thick hard coating layer (60) that is formed on a front surface of the resin film (50), said front surface being opposite to the first surface of the upper transparent electrode base member (1).

8. The input device (15) according to any one of claims 1 to 7, further comprising a drive circuit that drives plural ones of the upper transparent electrodes and plural ones of the lower transparent electrodes.

## Patentansprüche

1. Eingabevorrichtung (15), umfassend:
ein dickes oberes transparentes Elektrodenbasiselement (1), das auf einer ersten Fläche mit einer oberen transparenten Elektrodengruppe (5) bereitgestellt ist, die eine Vielzahl von oberen transparenten Elektroden (U1-U4), die jeweils eine rechteckige Form und eine Längsrichtung parallel zu einer X-Achse aufweisen, und Sammelschienen (20), die mindestens an einem der Enden in der Längsrichtung der oberen transparenten Elektroden bereitgestellt sind, beinhaltet; und
ein unteres transparentes Elektrodenbasiselement (2), das auf einer ersten Fläche mit einer unteren transparenten Elektrodengruppe (6) bereitgestellt ist, die eine Vielzahl von unteren transparenten Elektroden (L1-L6), die jeweils eine rechteckige Form und eine Längsrichtung parallel zu einer Y-Achse aufweisen, und Sammelschienen (20), die an mindestens einem der Enden in der Längsrichtung der unteren transparenten Elektroden bereitgestellt sind, beinhaltet, wobei die Fläche, die mit der unteren transparenten Elektrodengruppe (6) des unteren transparenten Elektrodenbasiselements (2) bereitgestellt ist, und die Fläche, die mit der oberen transparenten Elektrodengruppe (5) des oberen transparenten Elektrodenbasiselements (1) bereitgestellt ist, zueinander zeigen und an Umfangskanten aneinander gebondet sind;
die Eingabevorrichtung (15) weiter eine transparente druckempfindliche leitfähige Schicht (3) umfasst, die auf einem Bereich gebildet ist, der die transparente Elektrodengruppe an einer der Fläche, die mit der oberen transparenten Elektrodengruppe (5) des oberen transparenten Elektrodenbasiselements (1) bereitgestellt ist, und die Fläche, die mit der unteren transparenten Elektrodengruppe (6) des unteren transparenten Elektrodenbasiselements (2) bereitgestellt ist, enthält;
**dadurch gekennzeichnet, dass** die Eingabevorrichtung (15) nicht mit Punktabstandshaltern bereitgestellt ist, stattdessen eine transparente Flüssigformzwischenschicht (4) weiter zwischen der druckempfindlichen leitfähigen Schicht (3), die an dem einen der transparenten Elektrodenbasiselemente gebildet ist, und dem Bereich, der die transparente Elektrodengruppe des verbleibenden der transparenten Elektrodenbasiselemente enthält, eingefügt ist, wobei die transparente Flüssigformzwischenschicht (4) durch acrylbasierte, silikonbasierte, fluorbasierte oder alkoholbasierte Inertflüssigkeit konfiguriert ist;
und dadurch, dass die transparente Flüssigformzwischenschicht (4) beweglich ist und die transparente druckempfindliche leitfähige Schicht (3) so konfiguriert ist, dass, wenn Druckkraft auf eine zweite Fläche des oberen transparenten Elektrodenbasiselements (1) gegenüber der ersten Fläche des oberen transparenten Elektrodenbasiselements (1) aufgebracht wird, die aufgebrachte Kraft Quantentunnelstrom veranlasst, zwischen druckempfindlichen Teilchen (7), die in der druckempfindlichen leitfähigen Schicht (3) verstreut sind, zu fließen, was die obere transparente Elektrode und die untere transparente Elektrode unmittelbar unter einem gedrückten Punkt einander leitend verbinden lässt, und die Eingabevorrichtung (15) Positionskoordinierung detektiert, wo die Kraft entlang der zweiten Fläche des oberen transparenten Elektrodenbasiselements (1) aufgebracht wird.

2. Eingabevorrichtung (15) nach Anspruch 1, wobei die Sammelschienen (20) an beiden Enden in der Längsrichtung der oberen transparenten Elektroden und beiden Enden in Längsrichtung der unteren transparenten Elektroden bereitgestellt sind.

3. Eingabevorrichtung (15) nach Anspruch 1, wobei die Sammelschienen (20) an nur einem der Enden in der Längsrichtung der oberen transparenten Elektroden und nur einem der Enden in Längsrichtung der unteren transparenten Elektroden bereitgestellt sind.

4. Eingabevorrichtung (15) nach einem der Ansprüche 1 bis 3, weiter umfassend einen Z-Richtungsdetektor, der Variation in Größenordnung der Kraft detektiert, wenn die Druckkraft auf die zweite Fläche des oberen transparenten Elektrodenbasiselements (1) aufgebracht wird, wobei die aufgebrachte Kraft Strom veranlasst, zwischen den druckempfindlichen Teilchen in der druckempfindlichen leitfähigen Schicht (3) zu fließen und Variation in Widerstandswert zwischen der oberen transparenten Elektrode und der unteren transparenten Elektrode unmittelbar unter dem gedrückten Punkt auftritt.

5. Eingabevorrichtung (15) nach einem der Ansprüche 1 bis 4, wobei die Fläche, die mit der transparenten Elektrodengruppe des transparenten Elektrodenbasiselements bereitgestellt ist, einen Bereich aufweist, mit dem eine flexibel gedruckte Schaltung druckverbunden ist und eine flüssigkeitsabweisende Schicht (22) zwischen dem druckverbundenen Bereich und dem Bereich, der die transparente Elektrodengruppe enthält, bereitgestellt ist.

6. Eingabevorrichtung (15) nach einem der Ansprüche 1 bis 5, wobei Kleberpaste (23), die das obere transparente Elektrodenbasiselement (1) und das untere transparente Elektrodenbasiselement (2) an den Umfangskanten bondet, durch eine gehärtete Schicht konfiguriert ist, die aus einem härtenden Harz hergestellt ist.

7. Eingabevorrichtung (15) nach einem der Ansprüche 1 bis 6, wobei das obere transparente Elektrodenbasiselement (1) einen Harzfilm (50) und eine dicke Hartbeschichtungsschicht (60), die an einer Stirnfläche des Harzfilms (50) gebildet ist, aufweist, wobei die Stirnfläche der ersten Fläche des oberen transparenten Elektrodenbasiselements (1) gegenüberliegt.

8. Eingabevorrichtung (15) nach einem der Ansprüche 1 bis 7, weiter umfassend eine Antriebsschaltung, die mehrere der oberen transparenten Elektroden und mehrere der unteren transparenten Elektroden antreibt.

## Revendications

1. Dispositif d'entrée (15) comprenant :
un élément de base épais d'électrodes transparentes supérieures (1) prévu sur une première surface comportant un groupe d'électrodes transparentes supérieures (5) qui inclut une pluralité d'électrodes transparentes supérieures (U1-U4) ayant chacune une forme rectangulaire et une direction longitudinale parallèle à un axe X, et des barres omnibus (20) prévues au niveau de, au moins, l'une des extrémités dans la direction longitudinale des électrodes transparentes supérieures ; et
un élément de base d'électrodes transparentes inférieures (2) prévu sur une première surface comportant un groupe d'électrodes transparentes inférieures (6) qui inclut une pluralité d'électrodes transparentes inférieures (L1-L6) ayant chacune une forme rectangulaire et une direction longitudinale parallèle à un axe Y, et des barres omnibus (20) prévues au niveau de, au moins, l'une des extrémités dans la direction longitudinale des électrodes transparentes inférieures, la surface dotée du groupe d'électrodes transparentes inférieures (6) de l'élément de base d'électrodes transparentes inférieures (2) et la surface dotée du groupe d'électrodes transparentes supérieures (5) de l'élément de base d'électrodes transparentes supérieures (1) se faisant face et étant reliées au niveau de bords périphériques ;
le dispositif d'entrée (15) comprend en outre une couche conductrice transparente sensible à la pression (3) formée sur une région contenant le groupe d'électrodes transparentes sur l'une de la surface dotée du groupe d'électrodes transparentes supérieures (5) de l'élément de base d'électrodes transparentes supérieures (1) et de la surface dotée du groupe d'électrodes transparentes inférieures (6) de l'élément de base d'électrodes transparentes inférieures (2) ;
**caractérisé en ce que** le dispositif d'entrée (15) n'est pas doté de dispositifs d'espacement de points, au lieu de cela une couche intermédiaire transparente sous forme liquide (4) est en outre interposée entre la couche conductrice sensible à la pression (3) formée sur l'un des éléments de base d'électrodes transparentes et la région contenant le groupe d'électrodes transparentes du restant des éléments de base d'électrodes transparentes, dans lequel la couche intermédiaire transparente sous forme liquide (4) est configurée par un liquide inerte à base d'acrylique, à base de silicone, à base de fluor ou à base d'alcool ;
et **en ce que** la couche intermédiaire transparente sous forme liquide (4) est mobile et la couche conductrice transparente sensible à la pression (3) configurée de telle manière que, lorsqu'une force de pression est appliquée sur une seconde surface de l'élément de base d'électrodes transparentes supérieures (1) opposée à la première surface de l'élément de base d'électrodes transparentes supérieures (1), la force appliquée amène un courant à effet tunnel quantique à circuler entre des particules sensibles à la pression (7) dispersées dans la couche conductrice sensible à la pression (3), amenant ainsi l'électrode transparente supérieure et l'électrode transparente inférieure juste en dessous d'un point pressé à être conduites l'une avec l'autre, et le dispositif d'entrée (15) détectant les coordonnées de la position où la force est appliquée le long de la seconde surface de l'élément de base d'électrodes transparentes supérieures (1).

2. Dispositif d'entrée (15) selon la revendication 1, dans lequel les barres omnibus (20) sont prévues au niveau des deux extrémités dans la direction longitudinale des électrodes transparentes supérieures et au niveau des deux extrémités dans la direction longitudinale des électrodes transparentes inférieures.

3. Dispositif d'entrée (15) selon la revendication 1, dans lequel les barres omnibus (20) sont prévues au niveau de seulement l'une des extrémités dans la direction longitudinale des électrodes transparentes supérieures et seulement l'une des extrémités dans la direction longitudinale des électrodes transparentes inférieures.

4. Dispositif d'entrée (15) selon l'une quelconque des revendications 1 à 3, comprenant en outre un détecteur de direction Z qui détecte une variation de la magnitude de la force, lorsque la force de pression est appliquée sur la seconde surface de l'élément de base d'électrodes transparentes supérieures (1), la force appliquée amenant le courant à circuler entre les particules sensibles à la pression dans la couche conductrice sensible à la pression (3), et une variation de la valeur de la résistance ayant lieu entre l'électrode transparente supérieure et l'électrode transparente inférieure juste en dessous du point pressé.

5. Dispositif d'entrée (15) selon l'une quelconque des revendications 1 à 4, dans lequel la surface dotée du groupe d'électrodes transparentes de l'élément de base d'électrodes transparentes a une région à laquelle un circuit imprimé flexible est relié par pression, et une couche repoussant les liquides (22) est prévue entre la région reliée par pression et la région contenant le groupe d'électrodes transparentes.

6. Dispositif d'entrée (15) selon l'une quelconque des revendications 1 à 5, dans lequel une pâte adhésive (23) reliant l'élément de base d'électrodes transparentes supérieures (1) et l'élément de base d'électrodes transparentes inférieures (2) au niveau des bords périphériques est configurée par une couche durcie faite d'une résine durcissante.

7. Dispositif d'entrée (15) selon l'une quelconque des revendications 1 à 6, dans lequel l'élément de base d'électrodes transparentes supérieures (1) a un film en résine (50) et une couche de revêtement dure épaisse (60) qui est formée sur une surface avant du film en résine (50), ladite surface avant étant opposée à la première surface de l'élément de base d'électrodes transparentes supérieures (1).

8. Dispositif d'entrée (15) selon l'une quelconque des revendications 1 à 7, comprenant en outre un circuit de commande qui commande plusieurs des électrodes transparentes supérieures et plusieurs des électrodes transparentes inférieures.
